Europäisches Patentamt

European Patent Office

Office européen des brevets

(11) Publication number: **0 220 233 B1**

# EUROPEAN PATENT SPECIFICATION

(45) Date of publication of patent specification: **06.10.93**     (51) Int. Cl.⁵: **G01R 31/00**

(21) Application number: **86902664.1**

(22) Date of filing: **07.04.86**

(86) International application number:
**PCT/US86/00698**

(87) International publication number:
**WO 86/06176 (23.10.86 86/23)**

(54) **TARGET KEYS FOR WAFER PROBE ALIGNMENT.**

(30) Priority: **08.04.85 US 721166**

(43) Date of publication of application:
**06.05.87 Bulletin 87/19**

(45) Publication of the grant of the patent:
**06.10.93 Bulletin 93/40**

(84) Designated Contracting States:
**DE FR GB IT NL**

(56) References cited:
**US-A- 4 073 055       US-A- 4 356 223
US-A- 4 406 949       US-A- 4 419 013
US-A- 4 521 114       US-A- 4 540 277**

**PATENT ABSTRACTS OF JAPAN, vol. 9, no. 27, page 101 E 294; & JP-A-59 172 741**

(73) Proprietor: **SGS-THOMSON MICROELECTRONICS, INC. (a Delaware corp.)
1310 Electronics Drive
Carrollton, TX 75006(US)**

(72) Inventor: **LEUSCHNER, Horst
14430 North 19th Avenue
Phoenix, AZ 85023(US)**

(74) Representative: **Driver, Virginia Rozanne et al
Page White & Farrer
54 Doughty Street
London WC1N 2LS (GB)**

EP 0 220 233 B1

**Description**

FIELD OF THE INVENTION

The invention relates to an improved pattern of alignment keys on a semiconductor wafer which may be used to automatically and more accurately and expeditiously align test probes and laser systems with the geometries of chips on the wafer.

BACKGROUND OF THE INVENTION

When a semiconductor chip is tested for the first time, it is tested in wafer form; that is, there are many chips on a single wafer at the time of first test. Testing is accomplished by alignment of a probe card having as many probe needles as does the chip have connection pads. The probe needles are electrically connected to the testing machine allowing that machine to interconnect with the chip under test.

Alignment is accomplished either by manually (visually) scanning the wafer with the aid of a microscope or by viewing the wafer on a video monitor, while manually moving the wafer stage in the X and Y (lateral) directions and while, at the same time, adjusting the stage for axial rotation of the wafer to correct for rotational alignment error. The process is tedious and prone to error since it relies completely upon human judgment.

In recent years, it has become a common practice to include fusible links as a part of certain chip designs to allow selection or deselection of circuits on the chip at the time of initial testing. This practice has resulted in even closer attention being given to the alignment problem stated, above, so that a laser beam may be closely aligned to a given fusible link thereby allowing the selected link to be blown by the application of laser energy to it.

The laser "repair" system has the capability of recognizing certain highly reflective geometries (a key pattern) on a wafer with an accuracy within approximately 150 microns of its actual location. Alignment of the laser coordinate system or the wafer stage is then made to that alignment key pattern. Prior art practice is to place the key patterns in the scribe grid which lies between chips on the wafer. While this practice avoids the use of valuable chip "real estate", frequently the keys so placed are not sufficient to allow both X,Y offset correction, theta rotational correction, X-scale magnification correction and Y-scale magnification correction.

Very large scale integrated (VLSI) circuits are made by direct wafer steppers (DSW). This means that every print of a reticle on the wafer can have a translational and/or rotational misalignment with respect to a virtual absolute grid. Such a reticle usually contains at least two (or more) chips in a cluster for several reasons. First, if the reticle contains more than one chip, less stepping operations are required to step the chips across the wafer. Second, if more than one identical chip is on one reticle, a mask comparator can be used to find a random mask defect by comparing a video image of one chip to the next chip in the same reticle. Any differences may be legitimately attributed to random defects. With such a cluster arrangement, a chip may have different scribe grids on different sides of the chip. For example, where there are two chips in a reticle, there will be a full scribe line between the two chips in the middle of the reticle and one-half scribe line on the right, left, top and bottom sides of the reticle. Toward the edge of the reticle, and in place of the half scribe line, one chip could have a full scribe line and the other, none at all.

Where chips are stepped repetitively across a wafer, the full scribeline to the right of one chip is, at the same time, the left full scribeline of the chip stepped next to it. The scribeline between the chips is precisely that; a scribeline, and it has a width just sufficient for scribing a wafer for separation of the chips. In contrast, the scribeline toward the edge of the reticle must contain the alignment keys for the stepper alignment. The two chips on the reticle are self aligned with respect to each other, but this two chip cluster must be accurately aligned to the corresponding image on the wafer. Thus the scribeline around the perimeter of the reticle can have a different width than the scribeline in the middle of the reticle.

One can now appreciate the difference between the reticle alignment keys and the laser alignment keys. The reticle alignment keys are required only once per reticle but the laser alignment keys are required for every chip. It is absolutely impossible to put the laser alignment keys into the scribe grid if the scribe grid in the middle of the reticle has a width different from that in the perimeter of the reticle.

There are two expensive ways to solve the problem in the prior art. First, the scribe grid in the middle of the reticle can be made as wide as the larger grid at the perimeter of the reticle (which is larger because it contains the reticle alignment keys). This wastes silicon area and does not solve the laser key correlation problem, yet to be described. Second, the scribe at the edge (or perimeter) of the reticle could be made to equal a full width scribeline, all the way around, so that when the reticle is stepped, one full width scribeline

2

is touching another. This method would correlate the laser alignment keys to the chip but there would be adjacent keys in each corner, one belonging to the left chip and one to the right chip and the automatic alignment system might very well mistake one for the other. Another problem with the latter approach is that (as above) it wastes too much silicon area.

Since many advanced steppers do a site by site alignment, the blind stepping accuracy is quite poor; for example, three micron accuracy for blind stepping from one reticle image to the next. For any laser alignment key placement method in which the alignment in the right hand scribe of the reticle serves as the left hand alignment key for the chip to the right side, the laser or prober alignment accuracy is the built in inaccuracy plus the blind stepping inaccuracy of the DSW. This total inaccuracy affects not only the X and Y offset, but also the magnification sensitivity and in most eases leads to a miss of the fusible link to be repaired.

One system for controlling the alignment of a laser beam for accurate irradiation of links on a semiconductor chip is described in JP 59-172741. This document describes two alignment marks provided on the chip which have reference edges parallel to the scribe lines of the chip. However, the two alignment marks are not sufficient to provide full information on the alignment of the laser beam, for example, offset, rotation and X-and Y-magnification.

In US 4406949 the use of target structures is described for the alignment of a laser beam. However, the target structures are located between adjacent dies on a wafer. Thus, misalignment between the target structures and the dies may occur which would result in misalignment of the laser beam.

The foregoing shortcomings and problems with prior art keying systems are resolved by means of the key system pattern of the invention by placing a group of three sets of unique key patterns within the chip area of the silicon. This allows generation of the keys as a part of the data base for the chip masks.

The present invention provides therefore a system of alignment keys on each of a plurality of semiconductor chips on a wafer, each of the plurality of semiconductor chips on the wafer being defined by a set of four scribe lines defining a rectangular perimeter about the semiconductor chip, the system comprising: first key means disposed on each of the semiconductor chips within the perimeter and relatively close to a first scribe line of the four scribe lines; and second key means disposed on each of the semiconductor chips within the perimeter and relatively close to a second scribe line of the four scribe lines, with the first and second scribe lines being substantially parallel to each other and located at opposite edge portions of the semiconductor chip, each key means being arranged to reflect radiation from a scanning beam characterised by a third key means disposed on each of the semiconductor chips within the perimeter and relatively close to the first scribe line, the first and third key means being located so that a straight line drawn through a corresponding portion of the first and third key means is substantially parallel to the first scribe line and wherein each of the first, second and third key means comprises a first pair of reflective parallel stripes and a second pair of reflective stripes, the first pair of parallel stripes being parallel to the first and second scribe lines and the second pair of parallel stripes being perpendicular to the first pair of parallel stripes, each stripe providing two measurement edges for detection by a scanning beam.

The key patterns are placed as far apart as possible within the chip area and as close as possible to the repair fuses. This technique provides for 100% correlation between the laser alignment keys and the chip structure, whether that structure be a laser repair fuse or a bonding pad.

It is, therefore, an object of the invention to place laser keys on a semiconductor wafer within the chip perimeter.

It is another object of the invention to place laser keys on a semiconductor wafer within the chip perimeter and as close as possible to the repair fuses on the chip.

It is yet another object of the invention to place laser keys on a semiconductor wafer within the chip perimeter and as close as possible to the repair fuses on the chip and to arrange them in groups of three sets of keys to provide X, Y and rotational offset and X and Y scaling information for a prober or a laser repair beam.

The invention will be more readily understood after review of the Detailed Description of the Invention, infra, taken together with the drawings in which:

Figure 1 is a plan view of a set of keys which comprise the improved key pattern of the invention;

Figure 2 is a plan view of a single pair of key stripes; and

Figure 2A is a graph of the electrical response from a laser probe system which is coordinated with the position of the key Stripes of Figure 2.

## DETAILED DESCRIPTION OF THE INVENTION

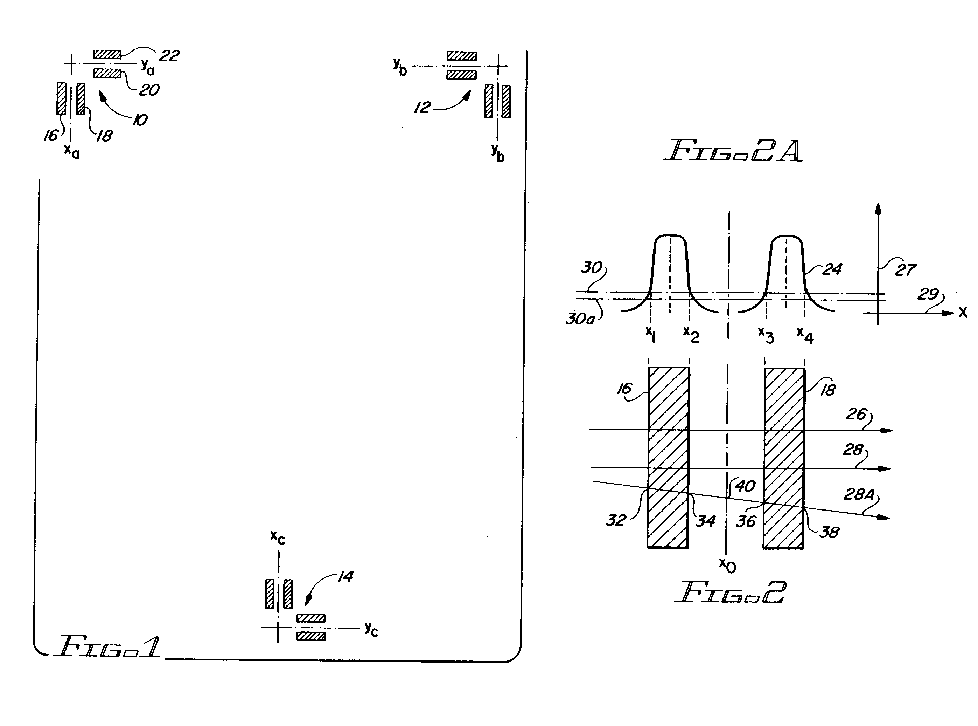

Figure 1 depicts, in plan view, a preferred embodiment of the key pattern of the invention. Three sets of key patterns, 10, 12, and 14 are disposed, preferably as metal stripes, at relatively widely spaced locations on the chip and within the chip perimeter (not shown). (Of course, Figure 1 is not drawn to scale since patterns 10, 12, 14 would appear too small to discern if it were.) Sets 10, 12, and 14 of patterns should be located as close as Possible to repair fuse locations on the chip in order to provide the maximum possible accuracy in automatically locating those fuse locations.

Within each of sets 10, 12 and 14 of key patterns, there are four stripes, shown typically at 16, 18, 20 and 22. Stripes 16 and 18 make up a vertical parallel pair of stripes and stripes 20 and 22 make up a horizontal parallel pair of stripes. When a laser sensor travels 26 over a pair of key stripes, for example 16 and 18, as shown in Figure 2, signal 24 is generated, as shown in Figure 2A. The amplitude (on abscissa 27 of the graph of Figure 2A) of signal 24 represents the intensity of the reflected light and the ordinate 29 represents time (and space) traveled by the beam along the X-axis. Similarly, the same result attains in the Y-axis.

It should be noted that the longer dimensions of stripes 16 - 22 are long enough to allow for some misalignment of the laser system. It does not matter whether the laser beam crosses stripes 16 and 18 on line 26 or on line 28. Furthermore, it will be seen that if line 26 or 28 is not perpendicular to stripes 16 and 18, as seen at line 28A, the system is self correcting insofar as the actual positional accuracy of the determination of the location of $X_0$ point 31 on the X axis. The calculation of $X_0$ point 31 is accomplished by looking at the time at which signal 24 crosses a threshold level 30. (See Figure 2A.) Those times may be represented by $X_1$, $X_2$, $X_3$ and $X_4$, which in reality are spacial distances, but are proportional to the time of crossing assuming that the beam travels at a steady rate. The calculation is as follows:

$$X_0 = (X_1 + X_2 + X_3 + X_4)/4 \qquad (1)$$

Equation (1) will clearly supply the value (or position) of $X_0$ even if threshold level 30 varies up or down, for example to level 30A. If scan path 26 or 28 is not perpendicular to stripes 16 and 18, that fact is also automatically corrected for by equation (1). The geometries of the patterns are such that these automatic corrections are built into the system.

For example, if the scanning beam crosses stripes 16 and 18 on an angle as shown at line 28A, the time (and space) between points 32 and 34 are equal to the time (and space) between points 36 and 38, the crossing points. These errors offset each other and the calculation of point 40 on ordinate line $X_0$ 31 is still accurate.

Furthermore, if threshold level line 30 were to shift to the location shown at line 30a (or to any other reasonable level), due to a long term drift in amplifiers or other phenomona, the result is the same: The accuracy of location of $X_0$ is just as precise because of the symmetry of the stripes and of the sensor system and its circuits.

The key pattern stripes are used to determine absolute position (within the tolerances of the system) of Xa, Ya, Xb, Yb, Xc and Yc in Figure 1 in the same manner as was described above in equation (1) for determining the absolute position of X0 in Figure 2. Once these absolute positions are attained, it may be seen that other useful information can be derived: Note:

| Positional Information | Function | (Item below) |
|---|---|---|
| Xa, Ya | Offset | 1 |
| Xb, Xc | Theta (rotation) | 2 |
| Xa, Xb | X-Magnification | 3 |
| Ya, Yc | Y-Magnification | 4 |

1. Xa and Ya can be used as a basic coordinate point from which to locate all points on the chip.

2. The distance Xb minus Xc should be equal to a known quantity if the chip is not off in rotational position, but that difference is greater than the known distance if the chip is rotated from a "square" position.

3. The value of Xb minus Xa is a measure of the X-Magnification (scaling).

4. The value of Yc minus Ya (or Yb) is a measure of Y-Magnification (scaling), once Ya is made to equal Yb or once Ya is corrected mathematically to equal Yb.

While the invention has been particularly shown and described herein with reference to preferred and other embodiments thereof, it will be understood by those skilled in the art that various modifications and changes may be made to the instant invention utilizing the principles of the invention as described herein without departing from the scope thereof as encompassed in the accompanying claims. Therefore, it is intended in the accompanying claims to cover all such equivalent variations as come within the scope of the invention as described without departing from the scope of the claims.

**Claims**

1.  A system of alignment keys on each of a plurality of semiconductor chips on a wafer, each of the plurality of semiconductor chips on the wafer being defined by a set of four scribe lines defining a rectangular perimeter about the semiconductor chip, the system comprising:
    first key means (10) disposed on each of the semiconductor chips within the perimeter and relatively close to a first scribe line of the four scribe lines; and
    second key means (14) disposed on each of the semiconductor chips within the perimeter and relatively close to a second scribe line of the four scribe lines, with the first and second scribe lines being substantially parallel to each other and located at opposite edge portions of the semiconductor chip, each key means being arranged to reflect radiation from a scanning beam characterised by a third key means (12) disposed on each of the semiconductor chips within the perimeter and relatively close to the first scribe line, the first and third key means being located so that a straight line drawn through a corresponding portion of the first and third key means is substantially parallel to the first scribe line and wherein each of the first, second and third key means comprises a first pair of reflective parallel stripes (20,22) and a second pair of reflective parallel stripes (16,18), the first pair of parallel stripes being parallel to the first and second scribe lines and the second pair of parallel stripes being perpendicular to the first pair of parallel stripes, each stripe providing two measurement edges for detection by the scanning beam.

2.  The system according to claim 1, characterised in that the first (10) and third (12) key means are located between the first scribe line and a device area on each of the plurality of semiconductor chips and the second key means (14) is located between the second scribe line and the device area on each of the plurality of semiconductor chips.

3.  The system according to either of claims 1 or 2, characterised in that the parallel pairs of stripes (16, 18; 20, 22) are disposed upon each of the plurality of semiconductor chips as a metal deposition.

4.  The system according to any preceding claim wherein the parallel stripes of each of the first (20, 22) and second (16,18) pairs are of equal width and are spaced apart by a predetermined distance.

5

**Patentansprüche**

1. System von Ausrichtungsschlüsseln auf jedem einer Mehrzahl von Halbleiterchips auf einem Wafer, wobei jeder der mehreren Halbleiterchips auf dem Wafer definiert ist durch einen Satz von vier Ritzlinien, die einen rechteckigen Umkreis um den Halbleiterchip bilden, wobei das System aufweist: eine erste Schlüsseleinrichtung (10), die auf jedem der Halbleiterchips innerhalb des Umkreises und relativ nahe bei einer ersten Ritzlinie der vier Ritzlinien angeordnet ist; sowie eine zweite Schlüsseleinrichtung (14), die auf jedem der Halbleiterchips innerhalb des Umkreises und relativ nahe bei einer zweiten Ritzlinie der vier Ritzlinien angeordnet ist, wobei die erste und die zweite Ritzlinie im wesentlichen parallel zueinander sind und sich an einander gegenüberliegenden Randbereichen des Halbleiterchips befinden und jede Schlüsseleinrichtung dazu ausgelegt ist, Strahlung von einem Abtaststrahl zu reflektieren, gekennzeichnet durch eine dritte Schlüsseleinrichtung (12), die auf jedem der Halbleiterchips innerhalb des Umkreises und relativ nahe bei der ersten Ritzlinie angeordnet ist, wobei die erste und die dritte Schlüsseleinrichtung derart angeordnet sind, daß eine durch einen entsprechenden Bereich der ersten und der dritten Schlüsseleinrichtung gezogene gerade Linie im wesentlichen parallel zu der ersten Ritzlinie ist, und daß die erste, die zweite und die dritte Schlüsseleinrichtung je ein erstes Paar reflektierender, paralleler Streifen (20, 22) und ein zweites Paar reflektierender, paralleler Streifen (16, 18) umfassen, wobei das erste Paar paralleler Streifen parallel zu der ersten und der zweiten Ritzlinie ist und das zweite Paar paralleler Streifen rechtwinklig zu dem ersten Paar paralleler Streifen ist und jeder Streifen zwei Meßränder für die Detektion durch den Abtaststrahl schafft.

2. System nach Anspruch 1, dadurch gekennzeichnet, daß sich die erste (10) und die dritte (12) Schlüsseleinrichtung zwischen der ersten Ritzlinie und einer Vorrichtungsfläche auf jedem der mehreren Halbleiterchips befinden und sich die zweite Schlüsseleinrichtung (14) zwischen der zweiten Ritzlinie und der Vorrichtungsfläche auf jedem der mehreren Halbleiterchips befindet.

3. System nach Anspruch 1 oder 2, dadurch gekennzeichnet, daß die parallelen Paare von Streifen (16, 18; 20, 22) auf jedem der mehreren Halbleiterchips in Form einer Metallablagerung ausgebildet sind.

4. System nach einem der vorausgehenden Ansprüche, bei dem die parallelen Streifen jedes ersten (20, 22) und zweiten (16, 18) Paares dieselbe Breite aufweisen und mit einer vorbestimmten Distanz voneinander beabstandet sind.

**Revendications**

1. Système de repères d'alignement sur chacune des puces à semi-conducteurs d'un ensemble sur une tranche, chacune des puces à semi-conducteurs de l'ensemble sur la tranche étant définie par un jeu de quatre lignes de traçage définissant un périmètre rectangulaire autour de la puce à semi-conducteurs, le système comprenant :
un premier moyen de repérage (10) disposé sur chacune des puces à semi-conducteurs à l'intérieur du périmètre et relativement proche d'une première ligne de traçage des quatre lignes de traçage ; et
un second moyen de repérage (14) disposé sur chacune des puces à semi-conducteurs à l'intérieur du périmètre et relativement proche d'une seconde ligne de traçage des quatre lignes de traçage, les première et seconde lignes de traçage étant sensiblement parallèles l'une à l'autre et placées sur des parties latérales opposées de la puce à semi-conducteurs, chaque moyen de repérage étant agencé pour réfléchir le rayonnement d'un rayon de balayage,
caractérisé par
un troisième moyen de repérage (12) disposé sur chacune des puces à semi-conducteurs à l'intérieur du périmètre et relativement proche de la première ligne de traçage, les premier et troisième moyens de repérage étant placés de sorte qu'une ligne droite tracée à travers une partie correspondante des premier et troisième moyens de repérage est sensiblement parallèle à la première ligne de traçage, et système dans lequel chacun des premier, second et troisième moyens de repérage comprend une première paire de bandes parallèles réfléchissantes (20, 22) et une seconde paire de bandes parallèles réfléchissantes (16, 18), la première paire de bandes parallèles étant parallèle aux première et seconde lignes de traçage et la seconde paire de bandes parallèles étant perpendiculaire à la première paire de bandes parallèles, chaque bande étant pourvue de deux bords de mesure pour la détection par le rayon de balayage.

2. Système selon la revendication 1, caractérisé en ce que les premier (10) et troisième (12) moyens de repérage sont placés entre la première ligne de traçage et une aire de dispositif sur chacune des puces à semi-conducteurs de l'ensemble et le second moyen de repérage (14) est placé entre la seconde ligne de traçage et l'aire de dispositif sur chacune des puces à semi-conducteurs de l'ensemble.

3. Système selon l'une ou l'autre des revendications 1 ou 2, caractérisé en ce que les paires de bandes parallèles (16, 18 ; 20, 22) sont disposées sur chacune des puces à semi-conducteurs de l'ensemble sous forme d'un dépôt métallique.

4. Système selon l'une quelconque des revendications précédentes, dans lequel les bandes parallèles de chacune des première (20, 22) et seconde (16, 18) paires sont de largeur égale et sont éloignées et séparées par une distance prédéterminée.

EP 0 220 233 B1

22
$y_a$
20
10
16 18
$x_a$

$y_b$
12
$y_b$

FIG.1

$x_c$
14
$y_c$

FIG.2A

30
30a
24
27
29
X
$x_1$ $x_2$ $x_3$ $x_4$

16
18
26
28
40
28A
32 34 36 38
$x_0$

FIG.2